# EUROPEAN PATENT APPLICATION

(11) **EP 4 664 458 A1**
(43) Date of publication of application: **17.12.2025**
(21) Application number: 25180947.1
(22) Date of filing: 05.06.2025
(51) Int. Cl.: G11C 7/22, G11C 11/417, G11C 8/16, G11C 11/412, G11C 11/418, H10B 10/00

(54) **SELF-TIMED MEMORY CIRCUIT UTILIZING DUMMY READ MEMORY CELLS AND DUMMY WRITE MEMORY CELLS HAVING FIXED DEVICE CAPACITIVE LOADS**

(30) Priority: 12.06.2024 US 202463659138 P; 27.05.2025 US 202519219405
(71) Applicant: STMicroelectronics International N.V., 1228 Plan-les-Ouates, Geneva (CH)
(72) Inventor: SHRIVASTAVA, Sant Swaroop, 282005 AGRA UTTAR PRADESH (IN); CHAWLA, Hitesh, 201301 NOIDA (IN); IKHLAS, Mohd Javed, 110025 DELHI (IN)
(74) Representative: Casalonga

(57) **Abstract**

A dummy SRAM cell included in a dummy row of a memory circuit includes first and second data storage nodes connected by cross-coupled latch circuitry. A first passgate transistor has a first source/drain node directly connected to the first data storage node, a second source/drain node directly connected to a ground node, and a gate node coupled to a dummy word line. The first data storage node is further directly connected to the ground node. A second passgate transistor has a first source/drain node directly connected to the second data storage node, a second source/drain node directly connected to the first source/drain node, and a gate node coupled to the dummy word line. A read transistor and transfer transistor are coupled in series. A gate node of the transfer transistor is coupled to a dummy read word line and a source/drain node of the transfer transistor is directly connected to the ground node.

## Description

### CROSS REFERENCE TO RELATED APPLICATIONS

This application claims priority to United States Provisional Application for Patent No. 63/659,138, filed June 12, 2024, which is incorporated herein by reference.

### TECHNICAL FIELD

The present invention generally relates to a self-timed memory circuit, for example of the static random access memory (SRAM) type, that utilizes dummy read memory cells and dummy write memory cells.

### BACKGROUND

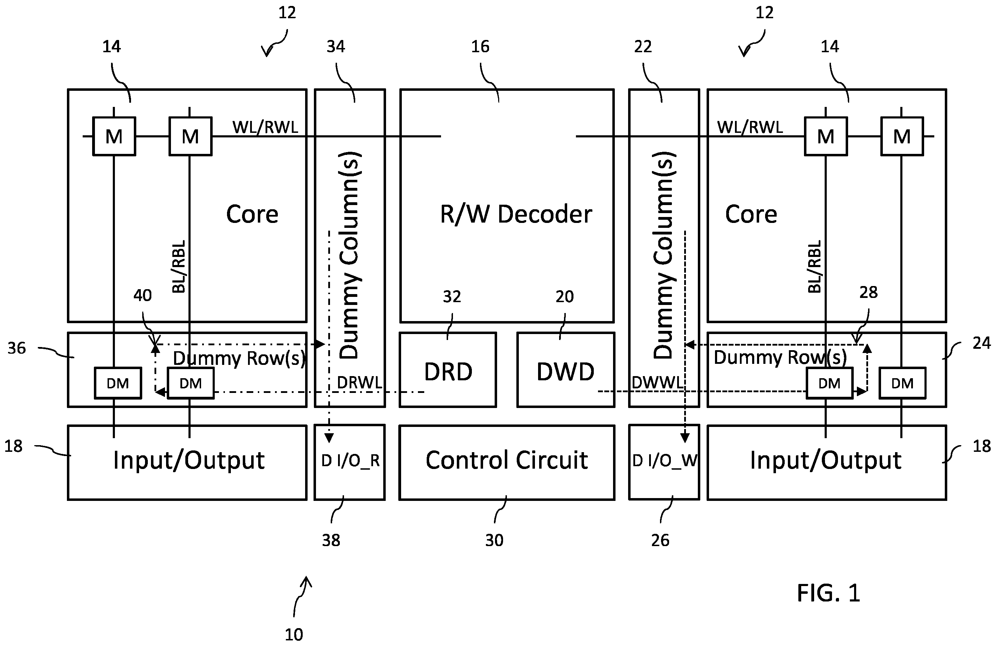

Reference is made to Figure 1 which shows a block diagram of a self-timed memory circuit 10. The memory circuit 10 includes a memory array 12 including core memory areas 14 each configured to store user data, a read/write row decoder circuit 16, and data input/output circuits 18. Each core memory area 14 includes a plurality of memory cells (M) arranged in a matrix of rows and columns.

During write operations, the read/write decoder circuit 16 decodes an input address and asserts a word line (WL) coupled to a row of memory cells in the core memory area 14. Data input to the input/output circuit 18 is written by write circuits for storage in the row of memory cells through write bit lines (BL) each connected to a column of memory cells in the core memory area 14. It is critical that the write circuits of the input/output circuit 18 be actuated by word line signals for a sufficient amount of time to ensure that the data is successfully written to the memory cells in the accessed row of the core memory area 14. The memory circuit 10 includes write self-time circuitry formed by a dummy write decoder (DWD) 20, one or more dummy columns 22 of memory cells in the array 12, one or more dummy rows 24 of memory cells in the array 12, and a dummy write input/output (D I/O_W) circuit 26. At the start of the write operation, when the read/write row decoder circuit 16 asserts the word line in response to decoding the address, the dummy write decoder (DWD) 20 asserts a dummy write word line (DWWL) coupled to the row of memory cells in the dummy row 24 and further to at least one memory cell in the column of memory cells of the dummy column 22. The dummy write input/output (D I/O_W) circuit 26 writes data to the memory cell(s) of the dummy column 22 and senses completion of the write operation. In response to that sensed completion, the control circuit 30 of the memory can control the read/write row decoder circuit 16 to timely terminate assertion of the word line signal on the word line.

For the write operation, the dummy row 24 is designed and positioned to track (e.g., emulate) the worst-case delay for each SRAM cell in the selected row of the core 14 to accept a new data value during a write operation. This accounts for the time it takes for the SRAM cell M to store the incoming value. The dummy column 22 tracks the worst-case delay associated with establishing the correct data value onto the bit lines, ensuring that the targeted SRAM cell M in the core 14 receives stores the proper data value. The dashed line 28 shown in Figure 1 illustrates the signal propagation path for the write self-time operation associated with the dummy write self-time (ST) signal (propagating along the dummy write word line DWWL of the dummy row 24 of memory cells and looping back to the dummy column 22 of memory cells). It will be noted that the signal propagation path 28 does not traverse all memory cells in the dummy row 24 (it needs to traverse only at or about one-half of the total number of cells) in order for the signal propagation time to emulate the amount of time needed for the word line signal to reach the memory cell farthest from the decoder 16. The word lines of the memory cells in the dummy row 24 that are not part of the signal propagation path 28 are grounded. In the case of the use of dual port memory cells with a write word line WL and a read word line RWL, all memory cells in the dummy row 24 for the write self-time circuit have the read word line RWL connected to ground.

During read operations, the read/write row decoder circuit 16 decodes an input address and asserts a read word line (RWL) coupled to a row of memory cells in the core memory area 14. Data stored in the memory cells at that row is output to read bit lines (RBL) each connected to a column of memory cells in the core memory area 14 and sensed by read circuits of the input/output circuit 18 for output. It is critical that sensing operation performed by the read circuits of the input/output circuit 18 be actuated no earlier than when the read data is made available on the read bit lines to ensure that the data is successfully read from the memory cells in the accessed row of the core memory area 14. The memory circuit 10 includes read self-time circuitry formed by a dummy read decoder (DRD) 32, one or more dummy columns 34 of memory cells in the array 12, one or more dummy rows 36 of memory cells in the array 12, and a dummy read input/output (D I/O_R) circuit 38. At the start of the read operation, when the read/write row decoder circuit 16 asserts the read word line (RWL) in response to decoding the address, the dummy read decoder (DRD) 32 asserts a dummy read word line (DRWL) coupled to the row of memory cells in the dummy row 36 and further to at least one memory cell in the column of memory cells of the dummy column 34. The dummy read input/output (D I/O_R) circuit 38 senses availability of read data from the memory cell(s) of the dummy column 34. In response to that sensed availability, the control circuit 30 of the memory can time control the actuation of the read sense circuits of the input/output circuit 18 to sense the read data on the read bit line RBL.

For the read operation, the dummy row 36 is designed and positioned to track (e.g., emulate) the worst-case delay for each SRAM cell in the selected row of the core 14 to reflect its state change onto its corresponding bit lines during a read operation. In addition, the dummy column 34 is designed and positioned to track (e.g., emulate) the worst-case bit line delay during a read operation, ensuring that the read circuits are timely actuated to successfully sense the read data value. The dot-dashed line 40 shown in Figure 1 illustrates the signal propagation path for the read self-time operation associated with the dummy read self-time (ST) signal (propagating along the dummy word line DWL of the dummy row 36 of memory cells and looping back to the dummy column 34 of memory cells). It will be noted that the signal propagation path 40 does not traverse all memory cells in the dummy row 36 (it needs to traverse only at or about one-half of the total number of cells) in order for the signal propagation time to emulate the amount of time needed for the word line signal to reach the memory cell farthest from the decoder 16. The word lines of the memory cells in the dummy row 36 that are not part of the signal propagation path 40 are grounded. In the case of the use of dual port memory cells with a write word line WL and a read word line RWL, all memory cells in the dummy row 36 for the read self-time circuit have the write word line WL connected to ground.

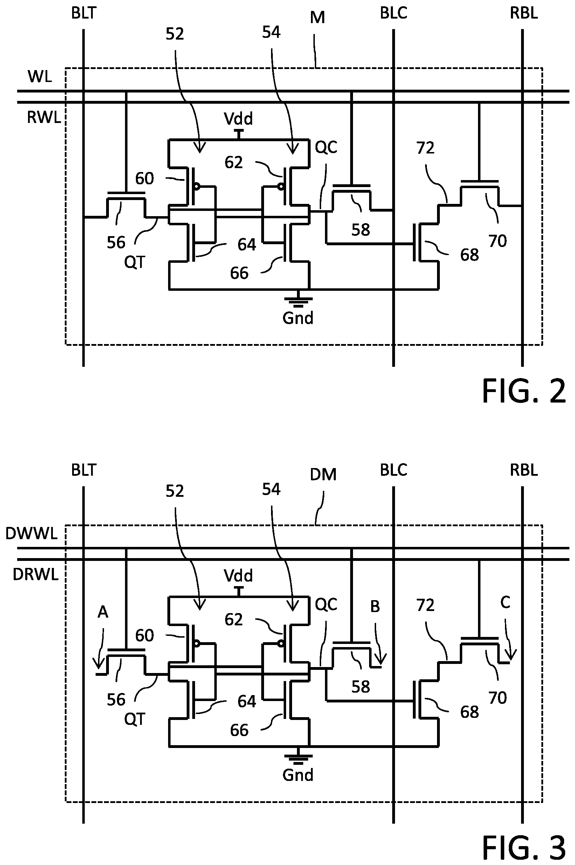

Reference is now made to Figure 2. Each memory cell M of the array 12 may comprise an 8T-type static random access memory (SRAM) cell (referred to above, for example, as a dual port type memory cell). The cell M includes two cross-coupled CMOS inverters 52 and 54, each inverter including a series connected p-channel and n-channel MOSFET transistor pair. The inputs and outputs of the inverters 52 and 54 are coupled to form a latch circuit having a true data storage node QT and a complement data storage node QC which store complementary logic states of the stored data bit. The cell M further includes two transfer (passgate) transistors 56 and 58 whose gate terminals are driven by a write word line WL. The source-drain path of transistor 56 (with associated source/drain nodes) is connected between the true data storage node QT and a node associated with a true bit line BLT. The source-drain path of transistor 58 (with associated source/drain node) is connected between the complement data storage node QC and a node associated with a complement bit line BLC. The source terminals of the p-channel transistors 60 and 62 in each inverter 52 and 54 are coupled to receive a high supply voltage (for example, Vdd) at a high supply node, while the source terminals of the n-channel transistors 64 and 66 in each inverter 52 and 54 are coupled to receive a low supply voltage (for example, ground (Gnd) reference) at a low supply node. A signal path between the read bit line RBL and the low supply voltage reference is formed by transistors 68 and 70 series coupled at intermediate node 72. The gate terminal of the (read) transistor 68 is coupled to the complement storage node QC and the gate terminal of the (transfer) transistor 70 is coupled to receive the signal on the read word line RWL.

During the write operation, the write word line WL is asserted by the decoder 16 with a word line signal and the input/output circuit 18 writes the data on the complementary bit lines BLT and BLC into the data storage nodes QT and QC of the 8T-type cell M. Self-timing of the write operation is controlled by the dummy write word line signal applied by DWD circuit 20 to the dummy write word line (DWWL) of the dummy row 24 and dummy column 22 to sense write completion at the D I/O_W circuit 26 and timely termination write word line signal actuation. During the read operation, the read word line RWL is asserted by the decoder 16 with a read word line signal and the data stored at data storage node QC of the 8T-type cell M is read out on the read bit line RBL to the input/output circuit 18. Self-timing of the read operation is controlled by the dummy read word line signal applied by DRD circuit 32 to the dummy read word line (DRWL) of the dummy row 36 and dummy column 34 to sense read data availability at the D I/O_R circuit 38 and timely assert the control signal for actuating input/output circuit 18 sense operation.

### SUMMARY

In an embodiment, a circuit comprises: a memory array including a core portion and a dummy row portion; wherein the core portion includes memory cells arranged in an array including plural rows and plural columns; wherein the dummy row portion includes dummy memory cells arranged in an array including at least one row and plural columns; a decoder circuit configured to apply word line signals to word lines connected to rows of the memory cells of the core portion; a dummy decoder circuit configured to apply a dummy write word line signal to a dummy write word line connected to the at least one row of the dummy memory cells of the dummy row portion; and an input/output circuit; wherein bit lines connected to columns of the memory cells of the core portion pass through the dummy row portion for connection to the input/output circuit; and wherein the dummy memory cells of the dummy row portion are disconnected from the bit lines.

Each dummy memory cell comprises: a first data storage node; and a first passgate transistor having a first source/drain node directly connected to the first data storage node, a second source/drain node directly connected to a ground node, and a gate node coupled to the dummy write word line; and wherein the first data storage node is further directly connected to the ground node.

In an embodiment, each dummy memory cell further comprises: a second data storage node; and a second passgate transistor having a first source/drain node directly connected to the second data storage node, a second source/drain node directly connected to the first source/drain node, and a gate node coupled to the dummy write word line.

The circuit further comprises a self-timing circuit for controlling timing of write operations on the core portion, said self-timing circuit configured to control actuation of a write drive circuit of the input/output circuit in response to the dummy write word line signal applied to the dummy write word line.

In an embodiment, a circuit comprises: a memory array including a core portion and a dummy row portion; wherein the core portion includes memory cells arranged in an array including plural rows and plural columns; wherein the dummy row portion includes dummy memory cells arranged in an array including at least one row and plural columns; a decoder circuit configured to apply word line signals to word lines connected to rows of the memory cells of the core portion; a dummy decoder circuit configured to apply a dummy read word line signal to a dummy read word line connected to the at least one row of the dummy memory cells of the dummy row portion; and an input/output circuit; wherein bit lines connected to columns of the memory cells of the core portion pass through the dummy row portion for connection to the input/output circuit; and wherein the dummy memory cells of the dummy row portion are disconnected from the bit lines.

Each dummy memory cell comprises: a read transistor; and a transfer transistor, wherein a gate node of the transfer transistor is coupled to the dummy read word line; wherein the read transistor and transfer transistor are coupled in series between a source/drain node and the ground node; and wherein the source/drain node of the transfer transistor is directly connected to the ground node.

The circuit further comprises a self-timing circuit for controlling timing of read operations on the core portion, said self-timing circuit configured to control actuation of a read sense circuit of the input/output circuit in response to the dummy read word line signal applied to the dummy read word line.

In an embodiment, a dummy static random access memory (SRAM) cell included in a dummy row of a memory circuit comprises: a first data storage node; a second data storage node; cross-coupled latch circuitry connected to the first and second data storage nodes; a first passgate transistor having a first source/drain node directly connected to the first data storage node, a second source/drain node directly connected to a ground node, and a gate node coupled to a dummy word line; wherein the first data storage node is further directly connected to the ground node; and a second passgate transistor having a first source/drain node directly connected to the second data storage node, a second source/drain node directly connected to the first source/drain node, and a gate node coupled to the dummy word line.

The dummy SRAM cell further comprises: a read transistor; and a transfer transistor, wherein a gate node of the transfer transistor is coupled to a dummy read word line; wherein the read transistor and transfer transistor are coupled in series between a further source/drain node and the ground node; and wherein the further drain/source node of the transfer transistor is directly connected to the ground node.

### BRIEF DESCRIPTION OF THE DRAWINGS

For a better understanding of the embodiments, reference will now be made by way of example only to the accompanying figures in which:
Figure 1 shows is a block diagram of a self-timed memory;
Figure 2 shows a circuit diagram for an 8T-type SRAM memory cell;
Figure 3 shows a circuit diagram for an 8T-type SRAM dummy memory cell;
Figure 4A is a schematic diagram of a column of the memory associated with the write self-time circuit;
Figure 4B is a schematic diagram of a column of the memory associated with the read self-time circuit; and
Figure 5 shows a circuit diagram for an improved 8T-type SRAM dummy memory cell.

### DETAILED DESCRIPTION

Reference is once again made to Figure 1. It will be noted that bit line(s) (BL/RBL) for the memory cells M of the core 14 portion of the array 12 pass through the dummy rows 24, 36 of memory cells in the array 12. However, these bit lines (e.g., the complementary bit lines BLT and BLC and the read bit line RBL) for the memory cells M in the core 14 portion are not connected to the corresponding bit lines for the memory cells DM in the dummy rows 24, 36. In other words, the dummy memory cells DM are disconnected from the complementary bit lines BLT and BLC and the read bit line RBL coupled to the memory cells M of the core 14. This is accomplished, for example, when laying out and fabricating the memory cells DM of the dummy rows 24, 36 to omit electrical via connections of the back end of line (BEOL) metallization levels from the bit line nodes of the memory cells DM in the dummy rows 24, 36 which would connect to (vertically-extending) bit lines connected to the bit line nodes of the memory cells M in the core 14 portion of the array 12. Because of this circuit configuration where the memory cells DM in the dummy rows 24, 36 are disconnected from the bit line extending between the core 14 and the input/output circuit 18, the node A (at a source/drain node of the passgate transistor 56), the node B (at a source/drain node of the passgate transistor 58), and the node C (at a source/drain node of the transfer transistor 70) are left floating as shown in Figure 3 which illustrates a circuit diagram for the 8T-type SRAM dummy memory cell DM used in the dummy rows 24, 36. The illustrated bit lines BLT, BLC and RBL in the dummy cell DM of Figure 3 are passing vertically through the dummy rows 24, 36 (without making connection the dummy memory cell DM), and are connected to the memory cells M of the core 14 (as shown in Figure 2) and are further connected to the input/output circuit 18 (for example, at data write driver and data sense circuits).

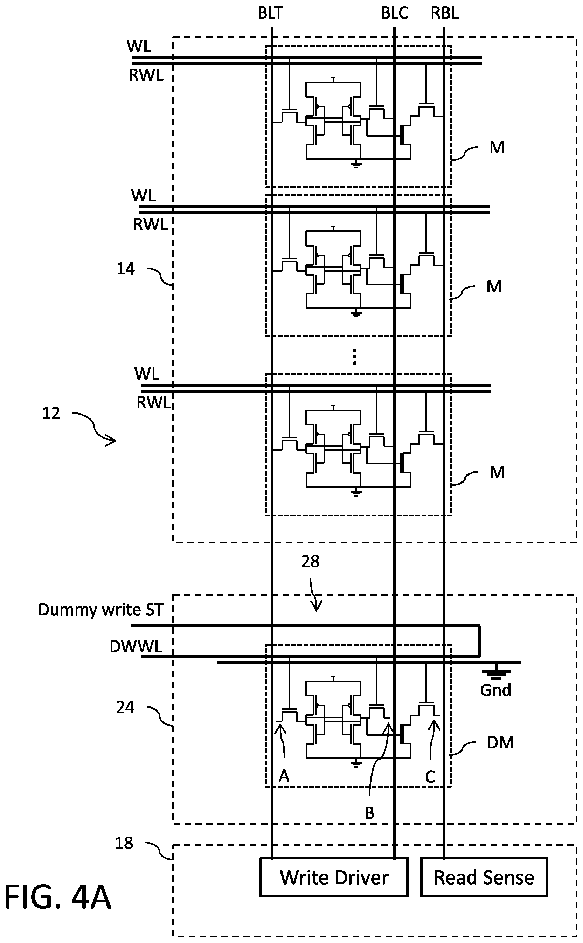

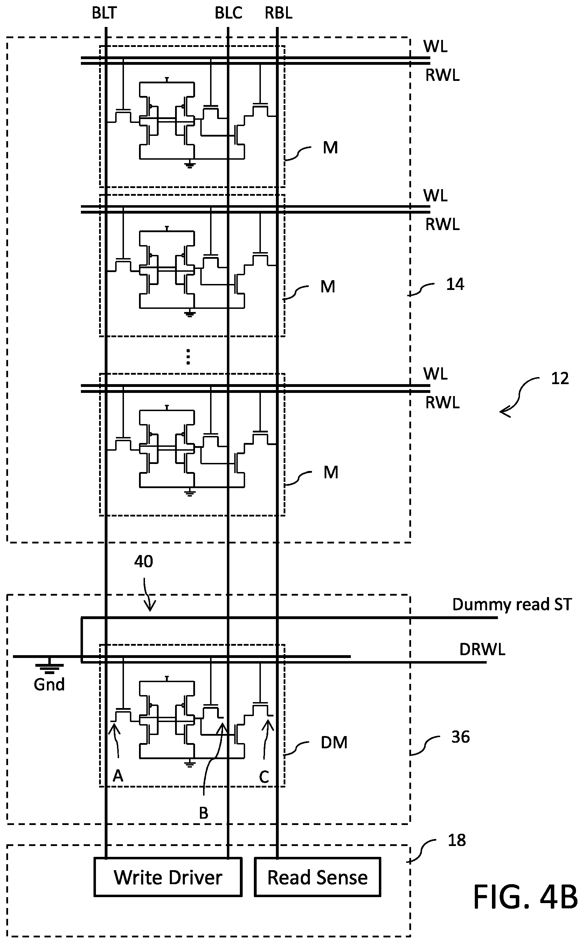

The configuration described above is illustrated in more detail in Figures 4A and 4B which each show, as an example, a single column of the array 12 including memory cells M (see, Figure 2) in the core 14, dummy memory cells DM (see, Figure 3) in the dummy rows 24, 36, a write driver circuit (of the I/O circuit 18) connected to the complementary bit lines BLT and BLC of the column, and a read sense circuit (of the I/O circuit 18) connected to the read bit line RBL of the column. The memory cell M in each row of the core 14 is connected to a write word line WL that is actuated by the decoder 16 (with a word line signal) during the write operation and a read word line RWL that is actuated by the decoder 16 (with a read word line signal) during the read operation.

With reference to Figure 4A, the dummy memory cell DM in the dummy row 24 which is part of the signal propagation path 28 has the gate nodes for the passgate transistors connected to the dummy write word line DWWL and the gate node for the transfer transistor connected to ground. However, the dummy memory cell DM in the dummy row 24 which is not part of the signal propagation path 28 has the gate nodes for the passgate and transfer transistors grounded. The dummy write word line DWWL is actuated by the dummy write decoder (DWD) 20 (with a word line signal) during the write operation. The complementary bit lines BLT and BLC and the read bit line RBL for the column are connected to each of the memory cells M in the core 14, but are disconnected at nodes A, B and C from the memory cells DM (see, Figure 3) in the dummy rows 24. Figure 4A further shows the loop back in the dummy rows 24 for the dummy write word line DWWL to provide the signal propagation path 28 for the dummy write self-time (ST) signal. As previously noted, this path 28 is provided to track (e.g., emulate) the worst-case delay for each SRAM cell in the selected row, with the dummy self-time signal being propagated to assist in determining when the operation to write data to the memory cells M in the dummy write column 22 is completed.

With reference to Figure 4B, the dummy memory cell DM in the dummy row 36 which is part of the signal propagation path 40 has the gate node for the transfer transistor connected to the dummy read word line DRWL and the gate nodes for the passgate transistors connected to ground. However, the dummy memory cell DM in the dummy row 36 which is not part of the signal propagation path 40 has the gate nodes for the passgate and transfer transistors grounded. The dummy read word line DRWL is actuated by the dummy read decoder (DRD) 32 (with a word line signal) during the read operation. The complementary bit lines BLT and BLC and the read bit line RBL for the column are connected to each of the memory cells M in the core 14, but are disconnected at nodes A, B and C from the memory cells DM (see, Figure 3) in the dummy rows 24. Figure 4B further shows the loop back in the dummy rows 36 for the dummy read word line DRWL to provide the signal propagation path 40 for the dummy read self-time (ST) signal. As previously noted, this path 40 is provided to track (e.g., emulate) the worst-case delay for each SRAM cell in the selected row, with the dummy self-time signal being propagated to assist in determining when the data read from the memory cells M in the dummy read column 34 is ready to be sensed.

The disconnection of the memory cells DM in the dummy rows 24, 36 at nodes A, B and C from the bit lines BLT, BLC and RBL leaves these nodes in a floating state. It will also be noted that the node 72 in the dummy memory cell DM will also be left in a floating state in the case where the data storage node QC initialized (and latched) at the logic 0 state during power up of the array 12. The floating states of the foregoing nodes of the dummy memory cell DM with the dummy rows 24, 36 is a problem because it can have an adverse effect on the rise time of the word line signals applied by the dummy write decoder (DWD) 20 and the dummy read decoder (DRD) 32 and propagated as the dummy write self-time (ST) signal and the dummy read self-time (ST) signal. The difference in signal rise times for the word line signals on the dummy word line and dummy read word line arise as a result of varying device capacitance and signal coupling at the dummy memory cells DM. This can adversely impact the accuracy of the self-time operation.

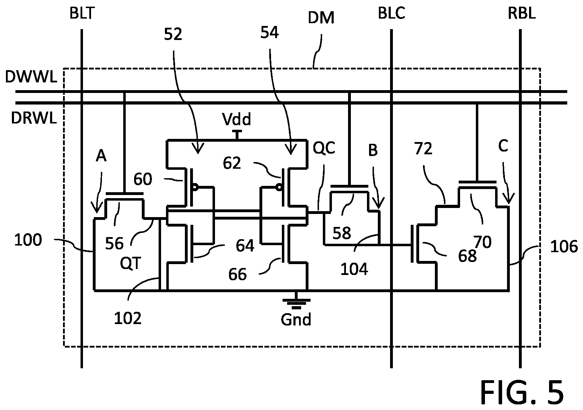

Reference is now made to Figure 5 which shows a circuit diagram for an improved dummy memory cell DM that may be used in the dummy rows 24, 36 of the circuit shown in Figure 1. Like references in Figures 3 and 5 refer to same or similar components, the description of which will not be provided again. The improved dummy memory cell DM of Figure 5 differs from the dummy memory cell DM of Figure 3 in the following ways:
1) the disconnection of the passgate transistor 56 at node A is replaced by a direct circuit connection 100 of the first source/drain node of the passgate transistor 56 (which otherwise would have been connected to the true bit line BLT) to ground, and the direct circuit connection 102 of the true data storage node QC at the second source/drain node of passgate transistor 56 to ground. The gate of the passgate transistor 56 is connected to the dummy word line DWL;
2) the disconnection of the passgate transistor 58 at node B is replaced by a direct circuit connection 104 of the first source/drain node of the passgate transistor 58 (which otherwise would have been connected to the complement bit line BLC) to the false data storage node QT at the second source/drain node of passgate transistor 58 (and gate of the read transistor 68). The gate of the passgate transistor 58 is connected to the dummy word line DWL; and
3) the disconnection of the transfer transistor 70 at node C is replaced by a direct circuit connection 106 of the source/drain node of the transfer transistor 70 (which would otherwise have been connected to the read bit line RBL) to ground. The gate of the transfer transistor 70 is connected to the dummy read word line DRWL.

In this context, a direct circuit connection (110, 102, 104, 106) is a short circuit connection which is defined and understood to mean and refer to a very low impedance electrical connection of one node to another node in a circuit; in other words, an intentional near zero resistance connection between two nodes.

A result of providing the direct circuit connections 100, 102, 104 and 106 is that the capacitive load on the dummy word lines DWL and RDWL is fixed because all of the noted nodes (i.e., the source and drain nodes of the passgate transistor 56 gated by the dummy word line DWL, the source and drain nodes of the passgate transistor 58 gated by the dummy word line DWL, and the source node of the transfer transistor 70) are all set at defined voltage levels. Specifically, the source and drain nodes of the passgate transistor 56 and the source node of the transfer transistor 70 are all at the ground voltage level, and the source and drain nodes of the passgate transistor 58 are all at the Vdd supply voltage level.

It will further be noted that the intermediate node 72 in this configuration is set at the defined ground voltage level (because the gate of transistor 68 is at the Vdd supply voltage level and transistor 68 is fully turned on).

The direct circuit connections 100, 102, 104 and 106 can be provided, for example, using conductive line and via connections formed in the back end of line (BEOL) metallization levels over each of the dummy memory cells DM. For example, specific metal patches at metallization level 1 of the BEOL can provide the necessary direct circuit connections. Those skilled in the art will know how to modify the design and layout of the memory cell to support the direct circuit connections.

The following connection implementations of the improved dummy memory cell DM are contemplated:
a) where the dummy memory cell DM is a part of the dummy row 24 and is connected to the signal propagation path 28, the dummy write word line DWWL connected to the gate nodes for the passgate transistors 56, 58 receives the dummy write word line signal from the DWD circuit 20 and the gate node for the transfer transistor 70 is connected to ground;
b) where the dummy memory cell DM is a part of the dummy row 24 and is not connected to the signal propagation path 28, the gate nodes for the passgate transistors 56, 58 are grounded and the gate node of the transfer transistor 70 is grounded;
c) where the dummy memory cell DM is part of the dummy row 36 and is connected to the signal propagation path 40, the dummy read word line DRWL connected to the gate of the transfer transistor 70 receives the dummy read word line signal from the DRD circuit 32 and the gate nodes for the passgate transistors 56, 58 are connected to ground; and
d) where the dummy memory cell DM is part of the dummy row 36 and is not connected to the signal propagation path 40, the gate nodes for the passgate transistors 56, 58 are grounded and the gate node of the transfer transistor 70 is grounded.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A circuit, comprising:
a memory array including a core portion and a dummy row portion;
wherein the core portion includes memory cells arranged in an array including plural rows and plural columns;
wherein the dummy row portion includes dummy memory cells arranged in an array including at least one row and plural columns;
a decoder circuit configured to apply word line signals to word lines connected to rows of the memory cells of the core portion;
a dummy decoder circuit configured to apply a dummy write word line signal to a dummy write word line connected to the at least one row of the dummy memory cells of the dummy row portion; and
an input/output circuit;
wherein bit lines connected to columns of the memory cells of the core portion pass through the dummy row portion for connection to the input/output circuit;
wherein the dummy memory cells of the dummy row portion are disconnected from the bit lines;
where each dummy memory cell comprises:
a first data storage node;
a first passgate transistor having a first source/drain node, a second source/drain node coupled to the first data storage node, and a gate node coupled to the dummy write word line;
a first direct circuit connection of the first source/drain node to a ground node; and
a second direct circuit connection of the first data storage node to the ground node.

2. The circuit of claim 1, wherein the first data storage node is a true data storage node of the dummy memory cell.

3. The circuit of claim1, wherein each dummy memory cell further comprises:
a second data storage node;
a second passgate transistor having a first source/drain node, a second source/drain node coupled to the second data storage node, and a gate node coupled to the dummy write word line; and
a third direct circuit connection of the second data storage node to the first source/drain node of the second passgate transistor.

4. The circuit of claim 3, wherein the second data storage node is a complement data storage node of the dummy memory cell.

5. The circuit of claim 3, wherein each dummy memory cell further comprises cross-coupled latch circuitry connected to the first and second data storage nodes.

6. The circuit of claim 3, further comprising a self-timing circuit for controlling timing of write operations on the core portion, said self-timing circuit configured to control actuation of a write driver circuit of the input/output circuit in response to the dummy write word line signal applied to the dummy write word line.

7. The circuit of claim 1, further comprising a self-timing circuit for controlling timing of write operations on the core portion, said self-timing circuit configured to control actuation of a write drive circuit of the input/output circuit in response to the dummy write word line signal applied to the dummy write word line.

8. A circuit, comprising:
a memory array including a core portion and a dummy row portion;
wherein the core portion includes memory cells arranged in an array including plural rows and plural columns;
wherein the dummy row portion includes dummy memory cells arranged in an array including at least one row and plural columns;
a decoder circuit configured to apply word line signals to word lines connected to rows of the memory cells of the core portion;
a dummy decoder circuit configured to apply a dummy read word line signal to a dummy read word line connected to the at least one row of the dummy memory cells of the dummy row portion; and
an input/output circuit;
wherein bit lines connected to columns of the memory cells of the core portion pass through the dummy row portion for connection to the input/output circuit;
wherein the dummy memory cells of the dummy row portion are disconnected from the bit lines;
wherein each dummy memory cell comprises:
a read transistor;
a transfer transistor, wherein a gate node of the transfer transistor is coupled to the dummy read word line;
wherein the read transistor and transfer transistor are coupled in series between a source/drain node and the ground node; and
a direct circuit connection of the drain/source node of the transfer transistor to the ground node.

9. The circuit of claim 8, wherein each dummy memory cell further comprises:
a data storage node; and
wherein a gate node of the read transistor is coupled to the data storage node.

10. The circuit of claim 8, further comprising a self-timing circuit for controlling timing of read operations on the core portion, said self-timing circuit configured to control actuation of a read sense circuit of the input/output circuit in response to the dummy read word line signal applied to the dummy read word line.

11. The circuit of claim 8, wherein the data storage node is one of a true data storage node or a false data storage node of the dummy memory cell.

12. A dummy static random access memory (SRAM) cell included in a dummy row of a memory circuit, comprising:
a first data storage node;
a second data storage node;
cross-coupled latch circuitry connected to the first and second data storage nodes;
a first passgate transistor having a first source/drain node with a direct circuit connection to the first data storage node, a second source/drain node with a direct circuit connection to a ground node, and a gate node coupled to a dummy word line;
wherein the first data storage node has a direct circuit connection to the ground node; and
a second passgate transistor having a first source/drain node with a direct circuit connection to the second data storage node, a second source/drain node with a direct circuit connection to the first source/drain node, and a gate node coupled to the dummy word line.

13. The dummy SRAM cell of claim 12, wherein the second source/drain node of the first passgate transistor is directly connected to the ground node using a metal line of a back end of line (BEOL) metallization level.

14. The dummy SRAM cell of claim 12, wherein the first data storage node of the first passgate transistor is further directly connected to the ground node using a metal line of a back end of line (BEOL) metallization level.

15. The dummy SRAM cell of claim 12, wherein the second source/drain node of the second passgate transistor is directly connected to the first source/drain node of the second passgate transistor using a metal line of a back end of line (BEOL) metallization level.

16. The dummy SRAM cell of claim 12, further comprising:
a read transistor;
a transfer transistor, wherein a gate node of the transfer transistor is coupled to a dummy read word line;
wherein the read transistor and transfer transistor are coupled in series between a further source/drain node and the ground node; and
wherein the further drain/source node of the transfer transistor has a direct circuit connection to the ground node.

17. The dummy SRAM cell of claim 16, wherein the further drain/source node of the transfer transistor is directly connected to the ground node using a metal line of a back end of line (BEOL) metallization level.
